(19) Europäisches Patentamt

European Patent Office

Office européen des brevets

(11) **EP 1 417 749 B1**

(12) **EUROPÄISCHE PATENTSCHRIFT**

(45) Veröffentlichungstag und Bekanntmachung des Hinweises auf die Patenterteilung:
**08.12.2004 Patentblatt 2004/50**

(21) Anmeldenummer: 02750781.3

(22) Anmeldetag: **07.06.2002**

(51) Int Cl.⁷: **H03D 3/04**

(86) Internationale Anmeldenummer:
**PCT/DE2002/002091**

(87) Internationale Veröffentlichungsnummer:
**WO 2003/017464 (27.02.2003 Gazette 2003/09)**

(54) **DEMODULATOR UND DEMODULATIONSVERFAHREN ZUR DEMODULATION VON EMPFANGSSIGNALEN**

DEMODULATOR AND DEMODULATION METHOD FOR DEMODULATING RECEIVED SIGNALS

DEMODULATEUR ET PROCEDE DE DEMODULATION PERMETTANT LA DEMODULATION DE SIGNAUX DE RECEPTION

(84) Benannte Vertragsstaaten:
**AT BE CH CY DE DK ES FI FR GB GR IE IT LI LU MC NL PT SE TR**

(30) Priorität: **06.08.2001 DE 10138567**

(43) Veröffentlichungstag der Anmeldung:
**12.05.2004 Patentblatt 2004/20**

(73) Patentinhaber: **Infineon Technologies AG**
**81669 München (DE)**

(72) Erfinder:
• **GREWING, Christian**
**40489 Düsseldorf (DE)**
• **HAMMES, Markus**
**46539 Dinslaken (DE)**
• **HANKE, André**
**40489 Düsseldorf (DE)**
• **VAN WAASEN, Stefan**
**47178 Duisburg (DE)**

(74) Vertreter: **Lange, Thomas, Dr.**
**Patentanwälte**
**Lambsdorff & Lange**
**Dingolfinger Strasse 6**
**81673 München (DE)**

(56) Entgegenhaltungen:
EP-A- 0 417 528       GB-A- 2 351 623
US-A- 4 558 284       US-A- 4 577 158
US-A- 5 974 096

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Demodulator zur Demodulation von hochfrequenten Signalen, und insbesondere von Mobilfunksignalen. Des Weiteren betrifft die Erfindung ein Verfahren zur Demodulation von hochfrequenten Signalen.

Um Empfangssignale, welche über einen Funkkanal übertragen wurden, demodulieren zu können, werden die hochfrequenten Empfangssignale üblicherweise zunächst auf eine niedrigere Frequenz heruntergemischt. Bei dieser Zwischenfrequenz findet dann die weitere Signalverarbeitung statt. Dabei können die Empfangssignale entweder auf die Frequenz Null oder auf eine von Null verschiedene Zwischenfrequenz heruntergemischt werden. Nach dem Heruntermischen der Signale muss sichergestellt werden, däss nur diejenigen Signalanteile, die innerhalb des durch den Kanal definierten Frequenzbands liegen, den weiteren Verarbeitungsstufen zugeführt werden. Zu diesem Zweck ist ein Kanalfilter vorgesehen, welches die unerwünschten Frequenzanteile unterdrückt. Bei diesem Kanalfilter kann es sich um einen Bandpass, und insbesondere um einen komplexen Bandpass handeln. Bei einem komplexen Bandpass werden auch Spiegelfrequenzanteile unterdrückt, die innerhalb des Durchlass-Bandbereichs liegen würden. Insbesondere kann das Kanalfilter als Polyphasenfilter ausgebildet sein.

Es hat sich herausgestellt, dass sich Kanalfilter, welche für die Verarbeitung von Signalen mit relativ hoher Zwischenfrequenz vorgesehen sind, nur schwer auf dem Chip integrieren lassen. Außerdem bereitet es bei Empfängerarchitekturen mit relativ hoher Zwischenfrequenz Probleme, die bei der Signalverarbeitung auf dem Chip geforderten Toleranzen einzuhalten. Man ist deshalb zur Verwendung von sogenannten Low-IF-Architekturen (IF: Intermediate Frequency) übergegangen, bei denen das Empfangssignal auf eine relativ niederfrequente Zwischenfrequenz heruntergemischt wird, die in etwa dem Frequenzabstand zwischen den einzelnen Kanälen entspricht. Bei der Verwendung niederfrequenter Trägerfrequenzen bereitet die Implementierung der Kanalfilter auf dem Chip keine Probleme. Auch die geforderten Toleranzen lassen sich hier einhalten. Durch die niedrige Trägerfrequenz des heruntergemischten Signals, die in einem Bereich liegt, in dem das Signalspektrum einen noch signifikanten Anteil hat, ergeben sich allerdings Probleme bei der Demodulation.

Der Demodulator für eine Low-IF Architektur wurde bislang üblicherweise als Quadrikorrelator ausgeführt (siehe z.B. GB 2 351 623 A). Bei einem Quadrikorrelator werden die vom Mischer kommenden Inphaseund Quadratursignale einem Filter zugeführt, dessen Grenzfrequenz in etwa der Trägerfrequenz der zugeführten Inphase- und Quadratursignale entspricht. Durch dieses Filter, welches beispielsweise als Polyphasenfilter ausgebildet sein kann, wird eine frequenzabhängige Phasenverschiebung der Eingangssignale verursacht. Anschließend werden die am Ausgang des Filters auftretenden phasenverschobenen Signale mit den am Eingang des Filters anliegenden Inphase- und Quadratursignalen kreuzweise korreliert. Auf diese Weise erhält man ein niederfrequentes Signal, dessen Amplitude ein Maß für die durch das Filter bewirkte Phasenverschiebung ist. Die Frequenzmodulation des Eingangssignals kann anhand dieses niederfrequenten Signals verfolgt werden. Dieses Signal kann anschließend mittels eines Entscheiders weiter ausgewertet werden.

Allerdings ist diesem Nutzsignal ein unerwünschter, höherfrequenter Anteil überlagert, der sich zwar zum Teil durch Summation der demodulierten Inphase- und Quadratursignale unterdrücken lässt, der die weitere Auswertung aber dennoch empfindlich stört. Insbesondere bei Nichtlinearitäten und Missmatches in der Schaltung kann dieses Störsignal eine beträchtliche Amplitude aufweisen. Wegen der niedrigen Trägerfrequenz in Low-IF Architekturen liegt die Frequenz des Störsignals nahe beim Spektrum des Datensignals. Dadurch wird eine nachfolgende Filterung, mit der sich dieses Störsignal ausblenden ließe, sehr schwierig. Ein weiterer Nachteil bei der Verwendung von Quadrikorrelatoren ist der relativ hohe Schaltungsaufwand, der zu ihrer Implementierung erforderlich ist.

Aufgabe der Erfindung ist es daher, einen Demodulator sowie ein Verfahren zur Demodulation von hochfrequenten Signalen zur Verfügung zu stellen, womit sich eine aufwandsarme und zuverlässige Demodulation des Empfangssignals bei Verwendung einer niederfrequenten Zwischenfrequenz realisieren lässt.

Diese Aufgabe der Erfindung wird durch einen Demodulator zur Demodulation von hochfrequenten Signalen gemäß Anspruch 1, durch eine Mobilfurikstation gemäß Anspruch 14 sowie durch ein Verfahren zur Demodulation von hochfrequenten Signalen gemäß Anspruch 16 gelöst.

Der erfindungsgemäße Demodulator zur Demodulation von hochfrequenten Signalen, und insbesondere von Mobilfunksignalen, weist einen Mischer auf, der das hochfrequente Signal in einen Zwischenfrequenzbereich heruntermischt, wobei der Mischer ein Inphasesignal sowie ein Quadratursignal erzeugt. Außerdem umfasst der Demodulator eine Signalwandlereinheit, welche das Inphasesignal sowie das Quadratursignal in ein Ausgabesignal von erhöhter Trägerfrequenz umsetzt. Dabei variiert die Signalwandlereinheit das Vorzeichen des Ausgabesignals in Abhängigkeit von dem Produkt der Vorzeichen des Inphase- und des Quadratursignals. Darüber hinaus umfasst der Demodulator Mittel zur Bestimmung der Periodendauer oder der Frequenz des durch die Signalwandlereinheit erzeugten Ausgabesignals.

Der erfindungsgemäße Demodulator ermöglicht eine zuverlässige Demodulation auch dann, wenn die Zwischenfrequenz so niedrig gewählt wird (beispielsweise 1 MHz), dass sie größenordnungsmäßig mit den höheren Frequenzen des Signalspektrums übereinstimmt. Bei Einsatz der erfindungsgemäßen Lösung ist eine Demodulation auch dann möglich, wenn der Zwischenfrequenzbereich mit dem Bereich der Datenfrequenzen des Signals überlappt.

Bei einer derartig niedrig gewählten Trägerfrequenz ist es nicht immer möglich, die Frequenzmodulation des Inphasesignals durch wiederholte Bestimmung der Periodendauer zu erfassen. Durch die niedrige Trägerfrequenz ist die Rate der Ereignisse pro übertragenem Datensymbol zu gering für eine kontinuierliche Verfolgung der Frequenzmodulation. Dasselbe gilt für das Quadratursignal.

Der Erfindung liegt die Idee zugrunde, dass man aus dem Inphase- und dem Quadratursignal ein schneller variierendes Signal erzeugen kann, dessen Ereignisrate pro Symbol hinreichend hoch ist, um eine kontinuierliche Verfolgung der Frequenzmodulation durch Messungen der Periodendauer zu ermöglichen. Dieses Ausgabesignal von erhöhter Trägerfrequenz wird mittels einer Signalwandlereinheit erzeugt, welche das Vorzeichen des Ausgabesignals in Abhängigkeit von dem Produkt der Vorzeichen des Inphase- und des Quadratursignals variiert.

Bei jedem Nulldurchgang des Inphasesignals ändert daher auch das Ausgabesignal der Signalwandlereinheit sein Vorzeichen. Entsprechend wird auch durch einen Nulldurchgang des Quadratursignals das Vorzeichen des Ausgabesignals geändert. Da die Nulldurchgänge des Inphasesignals und die Nulldurchgänge des Quadratursignals nur sehr selten koinzidieren, weist das Ausgabesignal der Signalwandlereinheit etwa die doppelte Zahl von Nulldurchgängen auf als das Inphase- bzw. das Quadratursignal alleine. Die Trägerfrequenz des Ausgabesignals der Signalwandlereinheit ist daher in etwa doppelt so groß wie die Trägerfrequenz des Inphase- bzw. des Quadratursignals, und dadurch wird die Ereignisrate pro übertragenem Symbol hinreichend groß, um die Frequenzmodulation verfolgen zu können.

Hierzu sind Mittel zur Bestimmung der Periodendauer vorgesehen, welche jeweils die Periodendauer zwischen aufeinanderfolgenden Nulldurchgängen des Ausgabesignals erfassen und ausgeben. Alternativ dazu können Mittel zur Bestimmung der Frequenz vorgesehen sein, mit denen jeweils die Frequenz des Ausgabesignals zwischen zwei aufeinanderfolgenden Nulldurchgängen gemessen wird. Auf diese Weise erzeugen die Mittel zur Bestimmung der Periodendauer oder der Frequenz eine Folge von Werten, aus denen die übertragenen Datensymbole gewonnen werden können.

Der erfindungsgemäße Demodulator ermöglicht die Verwendung. von sehr niedrigen Zwischenfrequenzen, welche mit dem Bereich der Datenfrequenzen des Signals überlappen. Dies ist insbesondere für die Auslegung der Kanalfilter von Vorteil, welche zwischen dem Mischer und der Signalwandlereinheit angeordnet werden und deren Grenzfrequenzen dementsprechend niedrig gewählt werden können. Die Implementierung und Integration der Kanalfilter auf den Empfängerbausteinen ist daher ohne Probleme möglich. Auch die für die Signalverarbeitung im Empfänger maßgeblichen Toleranzen können eingehalten werden.

Der erfindungsgemäße Demodulator eignet sich aber auch für den Einsatz mit mehrstufigen Mischern, welche das Hochfrequenzsignal zunächst auf ein erstes Zwischenfrequenzsignal heruntermischen, dieses Zwischenfrequenzsignal dann filtern und das gefilterte Signal anschließend auf eine zweite Zwischenfrequenz heruntermischen.

Der erfindungsgemäße Trick, das Inphase- sowie das Quadratursignal zu einem schneller variierenden Ausgabesignal zu kombinieren, ermöglicht den Bau eines sehr einfach aufgebauten Demodulators, welcher das empfangene Hochfrequenzsignal aber dennoch mit hoher Zuverlässigkeit zu demodulieren vermag. Dadurch wird eine attraktive Alternativlösung zu dem bislang verwendeten Quadrikorrelator zur Verfügung gestellt. Die Signalwandlereinheit, welche das Vorzeichen des Ausgabesignals in Abhängigkeit von dem Produkt der Vorzeichen des Inphaseund des Quadratursignals variiert, lässt sich mit geringem Schaltungsaufwand realisieren, beispielsweise mittels eines XOR-Gatters oder mit Hilfe einer Multipliziereinheit. Der Schaltungsaufwand für die Implementierung des erfindungsgemäßen Demodulators ist geringer als bei den Lösungen des Stands der Technik. Dadurch wird die erforderliche Chipfläche abgesenkt, und auch die Herstellungskosten werden verringert. Der erfindungsgemäße Demodulator ist daher einfacher, billiger und kleiner als der bislang verwendete Quadrikorrelator, ohne dass die Zuverlässigkeit der Demodulierung beeinträchtigt würde.

Gemäß einer vorteilhaften Ausführungsform der Erfindung umfasst der Demodulator dem Mischer nachgeschaltete Kanalfilter für das Inphasesignal und das Quadratursignal, welche Frequenzen außerhalb des Zwischenfrequenzbereichs zumindest zum Teil unterdrücken. Die Verwendung von Kanalfiltern im Empfangspfad ist wichtig, um die zu einem bestimmten Kanal gehörigen Empfangssignale von den Signalen anderer Kanäle unterscheiden zu können. Bei der erfindungsgemäßen Lösung werden die Kanalfilter zwischen Mischer und Signalwandlereinheit angeordnet. Zur Selektion des gewünschten Kanals werden die außerhalb des Zwischenfrequenzbereichs liegenden Frequenzen zumindest zum Teil unterdrückt. Da die erfindungsgemäße Lösung die Verwendung einer niederfrequenten zwischenfrequenz erlaubt, können auch die Grenzfrequenzen des Kanalfilters entsprechend niedrig gewählt werden, und deshalb bereitet die Implementierung des Kanalfilters auf dem Chip keine Probleme.

Dabei ist es von Vorteil, wenn es sich bei den Kanalfiltern um Bandpässe, und insbesondere um komplexe Bandpässe handelt. Mit Hilfe eines Bandpasses kann die untere sowie die obere Grenzfrequenz für den erlaubten Zwischenfrequenzbereich festgelegt werden. Frequenzen außerhalb des Zwischenfrequenzbereichs werden durch den Bandpass stark abgedämpft. Mit einem komplexen Bandpass lassen sich zusätzlich auch Spiegelfrequenzanteile, welche in den erlaubten Zwischenfrequenzbereich hineingemischt würden, wirkungsvoll unterdrücken. Daher werden der nachfolgenden Signalverarbeitung wirklich nur die Signalanteile zugeführt, die zu dem interessierenden Kanal gehören.

Gemäß einer vorteilhaften Ausführungsform der Erfindung umfasst die Signalwandlereinheit Mittel zur XOR-Verknüpfung des Inphasesignals und des Quadratursignals. Mit Hilfe eines XOR-Gatters lässt sich das Vorzeichen des Ausgabesignals der Signalwandlereinheit in Abhängigkeit von dem Produkt der Vorzeichen des Inphase- und des Quadratursignals variieren. Dies kann anhand der Wahrheitstabelle der XOR-Verknüpfung einfach nachvollzogen werden: Wenn beide Eingänge des XOR-Gatters auf "0" liegen oder beide Eingänge auf "1" liegen, so ergibt sich der Signalwert "1" am Ausgang des XOR-Gatters. Wenn also die Vorzeichen des Inphase- und des Quadratursignals übereinstimmen, so ergibt sich für das Ausgabesignal ein positives Vorzeichen. Wenn dagegen die Signalwerte der Eingangssignale des XOR-Gatters voneinander abweichen, wenn also am ersten Eingang die "0" und am zweiten Eingang die "1" oder am ersten Eingang die "1" und am zweiten Eingang die "0" anliegt, so ergibt sich am Ausgang des XOR-Gatters der Wert "0". Dies bedeutet, dass sich für den Fall von entgegengesetzten Vorzeichen des Inphase- und des Quadratursignals ein negatives Vorzeichen des Ausgabesignals der Signalwandlereinheit ergibt. Mit Mitteln zur XOR-Verknüpfung des Inphase- und des Quadratursignals lässt sich daher das Vorzeichen des Ausgabesignals in Abhängigkeit von dem Produkt der Vorzeichen des Inphaseund des Quadratursignals variieren. XOR-Gatter lassen sich mit geringem Schaltungsaufwand implementieren und benötigen nur wenig Platz auf dem Chip.

Dabei ist es insbesondere von Vorteil, wenn das Inphasesignal und das Quadratursignal als analoge Signale ausgeführt sind, und wenn die Mittel zur XOR-Verknüpfung des Inphase- und des Quadratursignals in Analogtechnik ausgeführt sind. Der Mischer mischt das hochfrequente Empfangssignal in den Zwischenfrequenzbereich herunter und erzeugt so ein analoges Inphase- sowie ein analoges Quadratursignal. Es ist daher von Vorteil, die Mittel zur XOR-Verknüpfung in Analogtechnik auszuführen, weil dann die vom Mischer erzeugten Inphase- sowie Quadratursignale ohne weitere Umwandlung verarbeitet werden können. Eine Implementierung des XOR-Gatters in Analogtechnik hat außerdem den Vorteil einer nur geringen Stromaufnahme. Durch Überabtastung des Ausgangssignals des XOR-Gatters kann auch bei einer analogen Implementierung des XOR-Gatters eine digitale Weiterverarbeitung der Signale vorgesehen werden.

Gemäß einer weiteren Ausführungsform der Erfindung umfasst die Signalwandlereinheit Mittel zur Limitierung und Pegelanpassung des Inphasesignals und des Quadratursignals, wobei die Mittel zur XOR-Verknüpfung des Inphase- und des Quadratursignals in digitaler Technik ausgeführt sind und die limitierten, pegelangepassten Signale verknüpfen. Ein "Limiter" stellt im Grunde einen Verstärker dar, der die vom Mischer gelieferten analogen Inphase- und Quadratursignale so stark verstärkt, dass ein geringfügig positiver Eingangswert in einen positiven Maximalwert umgesetzt wird. Entsprechend wird ein negativer Eingangswert in einen negativen Minimalwert umgesetzt. Das analoge Inphase- bzw. Quadratursignal wird also in ein Signal umgesetzt, welches nur zwei Signalpegel aufweist, einen positiven Maximalpegel sowie einen negativen Minimalpegel. Dadurch wird quasi eine Digitalisierung des Eingangssignals erzielt.

Ein typischer Limiter liefert am Ausgang ein Signal mit einer Amplitude von typischerweise 300 - 500 mV. Es ist daher vorteilhaft, zusätzlich zum Limiter einen nachgeschalteten Pegelumsetzer vorzusehen, der das vom Limiter gelieferte Signal in ein reguläres Logiksignal mit einer Signalamplitude von beispielsweise 2,5 V umsetzt. Wenn die Signalwandlereinheit derartige Mittel zur Limitierung und Pegelanpassung des Inphase- und des Quadratursignals umfasst, kann das nachfolgend angeordnete XOR-Gatter in Digitaltechnik ausgeführt sein. Durch Kombination der Mittel zur Limitierung und Pegelanpassung des Inphase- und des Quadratursignals mit einem digitalen XOR-Gatter kann wiederum erreicht werden, dass das Vorzeichen des Ausgabesignals in Abhängigkeit von dem Produkt der vorzeichen des Inphase- und des Quadratursignals variiert.

Gemäß einer alternativen Ausführungsform der Erfindung umfasst die Signalwandlereinheit eine Multiplikatorstufe zur Multiplikation des Inphasesignals und des Quadratursignals, wobei das Inphasesignal und des Quadratursignal als analoge Signale ausgeführt sind. Auch mit Hilfe einer Multiplikatorstufe, welche das analoge Inphasesignal mit dem analogen Quadratursignal multipliziert, lässt sich das Vorzeichen des Ausgabesignals der Signalwandlereinheit in Abhängigkeit von dem Produkt der Vorzeichen des Inphase- und des Quadratursignals variieren. Wenn sowohl das Inphase- als auch das Quadratursignal positive werte aufweisen, so ergibt sich auch für das Multiplikationsergebnis ein positiver Wert. Auch wenn sowohl das Inphase- als auch das Quadratursignal negative Werte aufweisen, ergibt sich ein positives Ergebnis der Multiplikation. Ein negatives Vorzeichen des Ausgabesignals der Multiplikatorstufe ergibt sich dagegen, wenn das Inphase- und des Quadratursignal entgegengesetzte Vorzeichen aufweisen.

Die Multiplikatorstufe erzeugt durch Multiplikation des langsam variierenden Inphasesignals mit dem langsam variierenden Quadratursignal ein schnell variierendes Ausgabesignal, welches verglichen mit dem Inphase- bzw. dem Quadratursignal eine in etwa verdoppelte Trägerfrequenz aufweist. Der schaltungstechnische Aufwand zur Implementierung eines analogen Multiplizierers ist gering, so dass sich auch bei dieser Ausführungsform die Signalwandlereinheit auf einfache und kostengünstige Weise realisieren lässt.

Es ist von Vorteil, wenn die Mittel zur Bestimmung der Periodendauer oder der Frequenz Flankendetektoren zur Detektion der Signalflanken des Ausgabesignals der Signalwandlereinheit aufweisen. Derartige Flankendetektoren erzeugen bei jeder ansteigenden oder abfallenden Signalflanke des Ausgabesignals der Signalwandlereinheit einen Triggerimpuls, der als Start- bzw. Stoppimpuls für die Bestimmung der Periodendauer dient. Derartige Flankendetektoren ermöglichen daher eine fortgesetzte Bestimmung der Periodendauer oder der Frequenz des von der Signalwandlereinheit gelieferten, schnell variierenden Ausgabesignals.

Es ist von Vorteil, wenn die Mittel zur Bestimmung der Periodendauer oder der Frequenz sowohl Flankendetektoren zur Detektion der ansteigenden Signalflanken als auch Flankendetektoren zur Detektion der abfallenden Signalflanken umfassen. Um zu einer zuverlässigen Demodulation des phasen- bzw. frequenzmodulierten Ausgabesignals der Signalwandlereinheit zu gelangen, muss die Periodendauer bzw. Frequenz dieses Signals hinreichend oft bestimmt werden. Zu diesem Zweck liefert die erfindungsgemäße Signalwandlereinheit ein Ausgabesignal, welches schneller oszilliert als das zugrunde liegende Inphase- bzw. Quadratursignal. Um die in diesem Signal enthaltene Information zum Zweck der Demodulierung möglichst vollständig extrahieren zu können, müssen sowohl die ansteigenden als auch die abfallenden Signalflanken in Triggerimpulse für die Periodendauermessung umgesetzt werden. Dadurch wird eine hohe Ereignisrate für die Triggerimpulse zur Periodendauermessung erzielt, so dass die Periodendauer bzw. die Frequenz für jede Halbwelle des Ausgabesignals der Signalwandlereinheit einmal bestimmt werden kann.

Gemäß einer vorteilhaften Ausführungsform der Erfindung weisen die Mittel zur Bestimmung der Periodendauer oder der Frequenz mindestens einen Zähldiskriminator zur Erfassung der Zeitintervalle zwischen aufeinanderfolgenden ansteigenden oder abfallenden Signalflanken auf. Mit einem Zähldiskriminator lässt sich die Länge der Zeitintervalle zwischen aufeinanderfolgenden ansteigenden oder abfallenden Signalflanken in digitaler Form bestimmen. Ein Vorteil bei der Verwendung von Zähldiskriminatoren zur Bestimmung der Periodendauer oder der Frequenz ist die hohe Genauigkeit des erzielten Ergebnisses. Da die Periodendauer digital gemessen wird, ist das Messergebnis weitgehend unabhängig von Prozessschwankungen und von Toleranzen der verwendeten Bauelemente.

Dabei ist es von Vorteil, wenn der mindestens eine Zähldiskriminator einen Zähler umfasst, dessen Zählerstand durch einen Zähltakt hochgezählt wird, wobei der Zähler mit jedem Impuls des Flankendetektors ausgelesen und rückgesetzt wird. Der Zähler erfasst also die Zahl der Zähltakte zwischen zwei aufeinanderfolgenden Impulsen des Flankendetektors. Da das Auslesen und Rücksetzen des Zählers in einem Schritt erfolgt, kann für direkt aufeinanderfolgende Perioden des Ausgabesignals der Signalwandlereinheit die Periodendauer durch den Zähler erfasst werden. Dies ermöglicht eine permanente Bestimmung der Periodendauer bzw. der Frequenz des Ausgabesignals der Signalwandlereinheit.

Gemäß einer alternativen Ausführungsform der Erfindung weisen die Mittel zur Bestimmung der Periodendauer oder der Frequenz mindestens einen Integrator auf, welcher das durch die Signalwandlereinheit erzeugte Ausgabesignal aufintegriert. Wenn das Ausgabesignal mit Hilfe eines XOR-Gatters erzeugt wird, dann ergibt sich als Ausgabesignal ein über eine Periodendauer hinweg konstantes Signal. Wenn dieses Signal dann mit Hilfe des Integrators aufintegriert wird, dann ist das am Ausgang des Integrators abgreifbare Signal zur Periodendauer des Ausgabesignals proportional. Der Integrator kann durch die Triggerimpulse des Flankendetektors rückgesetzt werden, um sodann über die Periodendauer der darauf folgenden Halbwelle des Ausgabesignals hinweg zu integrieren.

Gemäß einer weiteren vorteilhaften Ausführungsform der Erfindung umfassen die Mittel zur Bestimmung der Periodendauer oder der Frequenz mindestens ein 1/x-Glied, mit dem die erfassten Periodendauern in zur Frequenz proportionale Werte umwandelbar sind. Sowohl durch den Zähldiskriminator als auch durch den alternativ einsetzbaren Integrator wird bei der Auswertung des durch die Signalwandlereinheit erzeugten Ausgabesignals eine Folge von gemessenen Periodendauern erzeugt. Zwar ist es möglich, die Demodulation des frequenz- bzw. phasenmodulierten Eingangssignals anhand dieser Folge von Periodendauern vorzunehmen. Die Umwandlung der Folge von Periodendauern in eine Folge von Frequenzwerten hat allerdings den Vorteil, dass die weitere Auswertung und Demodulation dann anhand von frequenzproportionalen Werten erfolgen kann. Mit Hilfe einer Folge von frequenzproportionalen Werten lässt sich die Frequenzmodulation des Empfangssignals besser und mit höherer Genauigkeit auswerten, als dies mit der Folge von Periodendauern möglich wäre.

Der erfindungsgemäße Demodulator eignet sich für den Einsatz in einer Funkstation, und insbesondere für den Einsatz in einer Funkstation, die für die Datenübertragung gemäß einem der Standards DECT oder Bluetooth ausgelegt ist. Bei den Übertragungsstandards DECT und Bluetooth muss das empfangene Hochfrequenzsignal auf eine Zwischenfrequenz heruntergemischt werden. Grundsätzlich wäre es zwar auch denkbar, das empfangene Hochfrequenzsignal sofort auf die Frequenz Null herunterzumischen. Allerdings weist das empfangene Hochfrequenzsignal bei den Standards DECT und Bluetooth einen nicht zu vernachlässigenden Frequenzoffset auf. Beim Heruntermischen des Hochfrequenzsignals auf die Frequenz Null kann wegen dieses Frequenzoffsets nicht mehr eindeutig zwischen positiven und negativen Frequenzverschiebungen unterschieden werden, weil der Frequenzoffset den Frequenznullpunkt verschiebt. Daher muss das empfangene Hochfrequenzsignal bei den Standards DECT und Bluetooth auf eine Zwischenfrequenz ungleich Null heruntergemischt werden, wobei sich wegen der leichteren Implementierbarkeit der Kanalfilter und wegen der zu beachtenden Toleranzen die Verwendung einer möglichst niedrigen Zwischenfrequenz empfiehlt. Diese Anforderungen werden durch die erfindungsgemäße Lösung erfüllt.

Bei dem erfindungsgemäßen Verfahren zur Demodulation von hochfrequenten Signalen, insbesondere von Mobilfunksignalen, wird das hochfrequente Signal zunächst in einen Zwischenfrequenzbereich heruntergemischt. Dabei wird ein Inphasesignal sowie ein Quadratursignal erzeugt. Anschließend werden das Inphasesignal sowie das Quadratursignal in ein Ausgabesignal von erhöhter Trägerfrequenz umgewandelt, dessen Vorzeichen in Abhängigkeit von dem Produkt der Vorzeichen des Inphase- und des Quadratursignals variiert wird. Anschließend kann die. Periodendauer oder die Frequenz des Ausgabesignals bestimmt werden.

Bei Verwendung einer niederfrequenten Zwischenfrequenz ist die Oszillation des Inphase- und des Quadratursignals zu langsam, um eine zuverlässige Demodulation zu ermöglichen. Die erfindungsgemäße Lösung sieht deshalb vor, aus diesen beiden Signalen ein schneller oszillierendes Signal zu erzeugen, das sich dementsprechend leicht demodulieren lässt. Hierzu wird das Vorzeichen des erzeugten Ausgangssignals in Abhängigkeit von dem Produkt der Vorzeichen des Inphase- und des Quadratursignals variiert, und dadurch wird die Trägerfrequenz in etwa verdoppelt. Zur Realisierung des erfindungsgemäßen Verfahrens ist nur ein geringer baulicher Aufwand erforderlich, das Verfahren lässt sich sehr einfach implementieren.

Nachfolgend wird die Erfindung anhand von mehreren in der Zeichnung dargestellten Ausführungsbeispielen weiter beschrieben. Es zeigen:

Fig. 1     ein erstes Ausführungsbeispiel der Erfindung, bei dem zur Signalumwandlung ein XOR-Gatter und zur Periodendauerbestimmung ein Integrator eingesetzt wird;

Fig. 2A     ein zweites Ausführungsbeispiel der Erfindung, bei dem die Signalumwandlung mittels eines XOR-Gatters und die Periodendauerbestimmung mittels eines Zähldiskriminators vorgenommen wird;

Fig. 2B     ein drittes Ausführungsbeispiel der Erfindung, bei dem im Vergleich zu der in Fig. 2A gezeigten Lösung eine Vertauschung der Limitierungsstufe und des XOR-Gatters vorgenommen wurde;

Fig. 3A     ein viertes Ausführungsbeispiel der Erfindung, bei dem zur Signalumwandlung eine Multiplikatorstufe und zur Periodendauerbestimmung ein Integrator verwendet wird; und

Fig. 3B     ein fünftes Ausführungsbeispiel der Erfindung, bei dem zur Signalumwandlung eine Multiplikatorstufe und zur Periodendauerbestimmung ein zähldiskriminator eingesetzt wird.

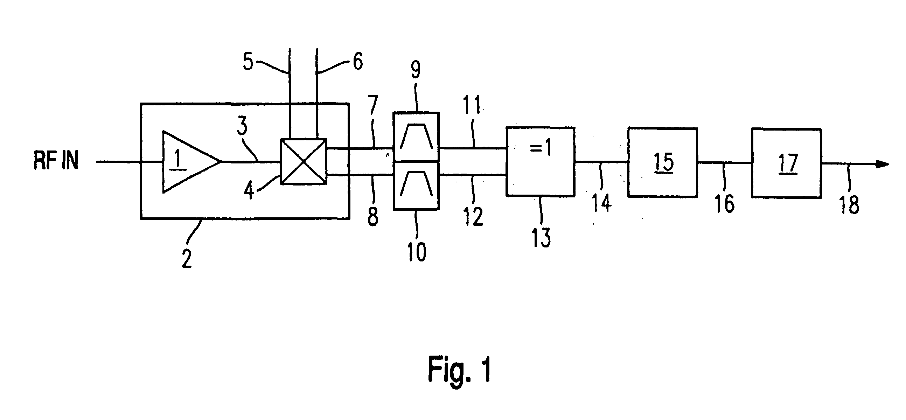

In Fig. 1 ist ein erstes Ausführungsbeispiel der Erfindung dargestellt. Hierbei wird das empfangene Hochfrequenzsignal RF IN dem Verstärker 1 der Hochfrequenzeinheit 2 zugeführt. Das verstärkte Hochfrequenzsignal 3 gelangt zum Mischer 4, wo es mit Hilfe der beiden um 90° gegeneinander phasenverschobenen Signale 5 und 6 des lokalen Oszillators in den Zwischenfrequenzbereich heruntergemischt wird. Die beiden so erzeugten Zwischenfrequenzsignale, das Inphasesignal 7 sowie das Quadratursignal 8, werden anschließend einer Kanalfilterung unterworfen, um außerhalb des Zwischenfrequenzbereichs liegende Signalanteile auszublenden. Hierzu sind das Kanalfilter 9 für das Inphasesignal sowie das Kanalfilter 10 für das Quadratursignal vorgesehen, an deren Ausgang das kanalgefilterte Inphasesignal 11 sowie das kanalgefilterte Quadratursignal 12 abgegriffen werden können. Bei den Kanalfiltern 9 und 10 kann es sich um komplexe Bandpassfilter handeln, welche zusätzlich zur Bandpassfilterung eine Spiegelfrequenzunterdrückung durchführen. Insbesondere können die Kanalfilter 9 und 10 als Polyphasenfilter ausgeführt sein.

Das kanalgefilterte Inphasesignal 11 sowie das kanalgefilterte Quadratursignal 12 werden dem analogen XOR-Gatter 13 zugeführt. Wenn beide Signale positiv sind, nimmt das Ausgabesignal 14 des XOR-Gatters den Wert 1 an. Auch wenn beide Signale negativ sind, nimmt das Ausgabesignal 14 des XOR-Gatters den Wert 1 an. Wenn sich die Vorzeichen des kanalgefilterten Inphasesignals 11 und des kanalgefilterten Quadratursignals 12 hingegen unterscheiden, dann nimmt das Ausgabesignal 14 des XOR-Gatters den Wert -1 an. Durch die XOR-Verknüpfung des langsam variierenden, Inphasesignals und des langsam variierenden Quadratursignals wird somit ein schnell oszillierendes. Ausgabesignal 14 generiert, dessen Trägerfrequenz ungefähr doppelt so hoch ist wie die Trägerfrequenz des zugrunde liegenden Inphase- bzw. Quadratursignals.

Zur fortwährenden Bestimmung der Periodendauer wird das Ausgabesignal 14 dem Integrator 15 zugeführt, der das Ausgabesignal 14 jeweils zwischen zwei aufeinanderfolgenden Vorzeichenwechseln aufintegriert. Am Ausgang des Integrators 15 liegt jeweils das aufintegrierte Signal 16 an, welches ein Maß für die Periodendauer zwischen zwei aufeinanderfolgenden Vorzeichenwechseln darstellt. Das aufintegrierte Signal 16 wird dem Abtast-Halteglied 17 zugeführt, das den Wert des aufintegrierten Signals 16 jeweils so lange speichert, bis der bisherige Wert des aufintegrierten Signals 16 durch einen neuen Wert ersetzt wird. Durch regelmäßiges Auslesen des Abtast-Halteglieds 17 erhält man als Signal 18 eine Folge von Periodenwerten, und anhand von diesen Werten kann die weitere Demodulation des empfangenen Signals vorgenommen werden. Es ist auch möglich, die Folge von Periodendauern vor der Demodulation mit Hilfe eines 1/x-Glieds in eine Folge von Frequenzwerten umzusetzen. Ausgehend von der Folge von Frequenzwerten lässt sich die Demodulation mit hoher Genauigkeit durchführen.

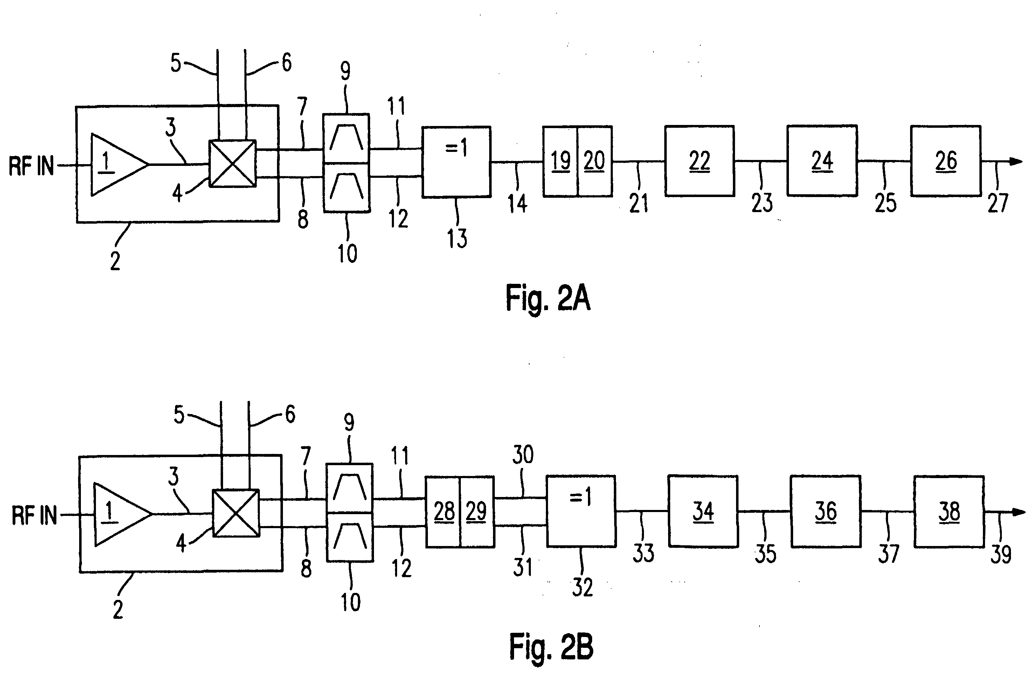

In Fig. 2A ist ein weiteres Ausführungsbeispiel der Erfindung gezeigt, bei dem die Bestimmung der Periodendauern nicht mit einem Integrator, sondern mit einem Zähldiskriminator vorgenommen wird. Wieder wird das Hochfrequenzsignal RF IN einem Verstärker 1 sowie einem nachgeschalteten Mischer 4 in einer Hochfrequenzeinheit 2 zugeführt, welche das Inphasesignal 7 sowie das Quadratursignal 8 erzeugt. Nach einer Filterung durch die Kanalfilter 9 und 10 werden das kanalgefilterte Inphasesignal 11 sowie das kanalgefilterte Quadratursignal 12 dem analogen XOR-Gatter 13 zugeführt, an dessen Ausgang das schnell variierende Ausgabesignal 14 anliegt. Das Vorzeichen. des Ausgabesignals 14 wird in Abhängigkeit von dem Produkt der Vorzeichen des kanalgefilterten Inphasesignals 11 sowie des kanalgefilterten Quadratursignals 12 variiert. Das Ausgabesignal 14 liegt am Eingang der Limitiereinheit 19 an, welche das Ausgabesignal 14 so stark verstärkt, dass am Ausgang der Limitiereinheit 19 entweder ein positiver Maximalwert von +300 bis +500 mV oder ein negativer Minimalwert von -300 bis - 500 mV anliegt. Jeder positive Eingangswert der Limitiereinheit wird also in den positiven Maximalwert umgewandelt, während jeder negative Eingangswert in den negativen Minimalwert umgesetzt wird. Dadurch erhält man ein quasi-digitales "Railto-Rail"-Signal, und dieses Signal wird dem nachfolgend angeordneten Pegelumsetzer 20 zugeführt. Der Pegelumsetzer 20 setzt das limitierte Signal, dessen Amplituden ±300 bis ±500 mV betragen, auf Signalpegel von einigen Volt (typischerweise 2,5 V) um. Das limitierte, pegelangepasste Signal 21 wird dem Flankendetektor 22 zugeführt, welcher sowohl Mittel zur Detektion von ansteigenden Signalflanken als auch Mittel zur Detektion von abfallenden Signalflanken umfasst und bei jeder auftretenden Signalflanke einen Triggerimpuls erzeugt. Das Triggersignal 23 liegt am Eingang des Zähldiskriminators 24 an, welcher jeweils die Periodendauer zwischen zwei aufeinanderfolgenden Triggerimpulsen misst. Hierzu umfasst der Zähldiskriminators 24 einen Zähler, dessen Zählerstand durch einen hochfrequenten Zähltakt hochgezählt wird. Typischerweise wird ein Zähltakt von ca. 100 MHz verwendet. Bei jedem Triggerpuls, der am Eingang des Zähldiskriminators 24 auftritt, wird der aktuelle Zählerstand ausgelesen; außerdem wird der Zähler auf Null zurückgesetzt. Der so ermittelte Zählerstand 25 stellt ein Maß für die Zeitdauer der vorangehenden Periode des Ausgabesignals 14 dar. Der Zählerstand 25 wird jeweils zum Abtast-Halteglied 26 weitergeleitet und überschreibt dort den zuletzt gespeicherten Wert. Durch regelmäßiges Auslesen, des Abtast-Halteglieds 26 erhält man als Signal 27 eine Folge von digital gemessenen Periodendauern, und anhand dieser Folge kann dann die weitere Demodulation des Signals vorgenommen werden.

Grundsätzlich kann die Analog-/Digital-Wandlung der in den Zwischenfrequenzbereich heruntergemischten Signale vor dem XOR-Gatter, nach dem XOR-Gatter oder nach dem Abtast-Halteglied durchgeführt werden. während bei der in Fig. 2A gezeigten Ausführungsform die Limitierung und Pegelumsetzung nach der XOR-Verknüpfung des Inphase- und des Quadratursignals durchgeführt wurde, verarbeitet das XOR-Gatter bei der in Fig. 2B gezeigten Lösung bereits die limitierten und pegelangepassten Signale. Hierzu werden sowohl das kanalgefilterte Inphasesignal 11 als auch das kanalgefilterte Quadratursignal 12 der Limitiereinheit 28 zugeführt, die sowohl das Inphase- als auch das Quadratursignal in quasi-digitale "Rail-to-Rail" Signale umsetzt, die dann vom Pegelumsetzer 29 in das limitierte, pegelangepasste Inphasesignal 30 und in das limitierte, pegelangepasste Quadratursignal 31 umgesetzt werden. Diese beiden Signale werden von dem digitalen XOR-Gatter 32 in ein schnell oszillierendes Ausgabesignal 33 umgesetzt.

Der Flankendetektor 34 ermittelt die positiven und negativen Signalflanken und übermittelt ein Triggersignal 35 zum Zähldiskriminator 36. Der Zähldiskriminator 36 misst die Zeitintervalle zwischen aufeinanderfolgenden Triggerimpulsen und generiert so eine Folge von Periodendauern, die als Signal 37 zum Abtast-Halteglied 38 übermittelt wird. Dort werden die Werte der Periodendauer zwischengespeichert. Durch Auslesen des Abtast-Halteglieds 38 wird das Signal 39 erhalten, das dann zur weiteren Signaldemodulation herangezogen wird.

Das erfindungsgemäße Verfahren eignet sich insbesondere zur Demodulation von Empfangssignalen, welche entsprechend dem DECT- oder gemäß dem Bluetooth-Standard übertragen werden; der Einsatz der Erfindung ist aber nicht auf diese Übertragungssysteme beschränkt. Bei den Standards DECT und Bluetooth wird das Modulationsverfahren GMSK (Gaussian Minimum Shift Keying) verwendet, bei dem die Frequenz- und Phasenänderungen zwischen aufeinanderfolgend übertragenen Datensymbolen nicht abrupt erfolgen. Stattdessen werden weiche, durch Gauß-Pulse gesteuerte Überblendungen zwischen den verschiedenen Frequenz- und Phasenzuständen vorgenommen.

Bei Verwendung einer niedrigen Zwischenfrequenz von 1 MHz ergibt sich dabei ein Frequenzbereich von 1 MHz ± 170 kHz für das Inphase- und das Quadratursignal. Bei dem erfindungsgemäßen Verfahren wird die Trägerfrequenz des auszuwertenden Signals durch Verknüpfung des Inphase- sowie des Quadratursignals verdoppelt. Zur Auswertung dieses Signals werden sowohl die positiven als auch die negativen Signalflanken erfasst, so dass während jeder Taktperiode des Inphasesignals vier Periodendauermessungen durchgeführt werden. Wenn der Zähler des Zähldiskriminators mit einer Frequenz von 100 MHz betrieben wird, so ergibt sich für die Zahl der während einer Periodendauer gezählten Zähltakte ein Wertebereich von:

$$\left( \frac{(1\ \text{MHz} \pm 170\ \text{kHz}) \cdot 4}{100\ \text{MHz}} \right)^{-1}$$

Für das frequenzmodulierte Zwischenfrequenzsignal werden daher pro Periodendauer zwischen 21 Zählpulsen und 30 Zählpulsen ermittelt. Die Durchführung von vier Periodendauer- bzw. Frequenzmessungen pro Grundschwingung des Zwischenfrequenzsignals bietet bei dieser Auflösung eine hinreichende Genauigkeit für die Verfolgung und Auswertung der Frequenzmodulation.

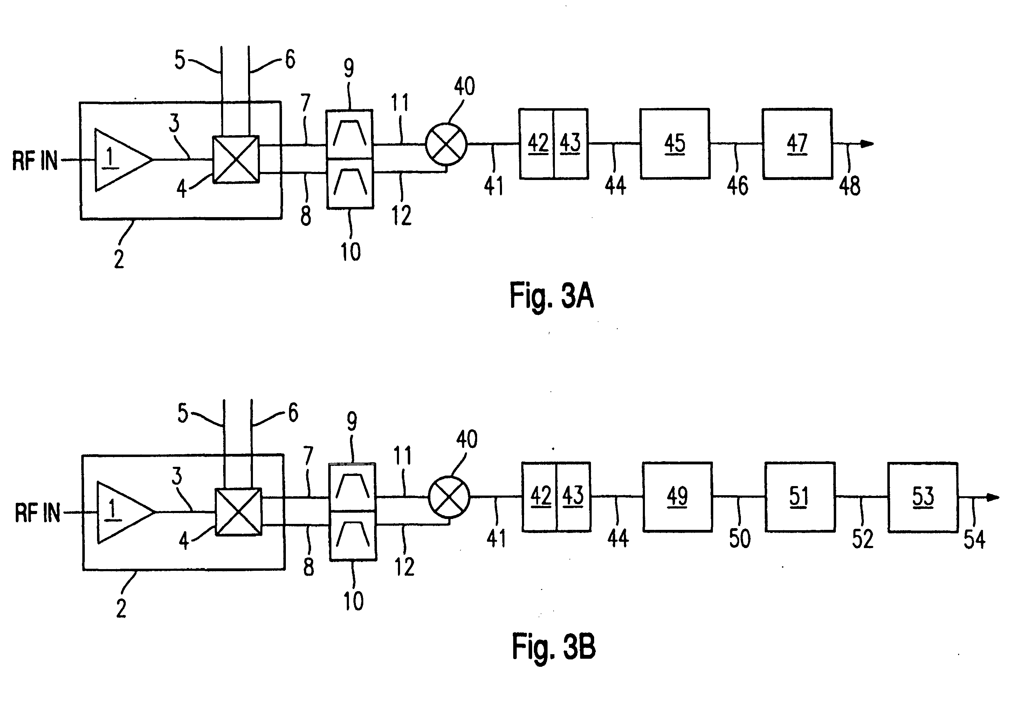

In den Fig. 3A und 3B sind alternative Ausführungsformen der Erfindung gezeigt, bei denen zur Verknüpfung des. Inphase- und des Quadratursignals eine Multiplikatorstufe eingesetzt wird. Dies kann anhand von Fig. 3A erkannt werden. In der Multiplikatorstufe 40 wird das kanalgefilterte Inphasesignal 11 mit dem kanalgefilterten Quadratursignal 12 multipliziert, um so das analoge Ausgabesignal 41 zu erhalten. Dabei variiert das vorzeichen des analogen Ausgabesignals 41 in Abhängigkeit von dem Produkt der Vorzeichen des Inphasesignals 11 und des Quadratursignals 12. Als Folge davon oszilliert das analoge Ausgabesignal 41 etwa doppelt so schnelle wie die zugrunde liegenden Zwischenfrequenzsignale 11 und 12. Das analoge Ausgabesignal 41 wird durch die Limitiereinheit 42 und den Pegelumsetzer 43 in das limitierte, pegelangepasste Ausgabesignal 44 umgewandelt. Bei der in Fig. 3A gezeigten Lösung wird dieses Signal mit Hilfe des Integrators 45 weiter ausgewertet. Der Integrator 45 integriert das Ausgabesignal 44 jeweils zwischen zwei aufeinanderfolgenden Signalflanken und erzeugt so einen analogen Messwert für die Periodendauer. Dieses aufintegrierte Signal 46 wird zum Abtast-Halteglied 47 geführt und dort zwischengespeichert. Aus dem Abtast-Halteglied 47 kann das Signal 48 als Folge von Periodendauern ausgelesen werden, das zur Demodulation herangezogen wird.

Auch bei der in Fig. 3B gezeigten Lösung wird das analoge Ausgabesignal 41 der Multiplikatorstufe 40 mit Hilfe der Limitiereinheit 42 und dem Pegelanpasser 43 in ein limitiertes, pegelangepasstes Ausgabesignal 44 umgewandelt. Dieses Signal wird dem Flankendetektor 49 zugeführt, der bei jeder positiven oder negativen Signalflanke einen Triggerimpuls generiert. Der Zähldiskriminator 51 ermittelt anhand des Triggersignals 50 digitale Messwerte für die Intervall-Längen zwischen aufeinanderfolgenden Triggerimpulsen. Diese Periodendauer-Werte werden als Signal 52 dem Abtast-Halteglied 53 zugeführt und dort zwischengespeichert. Durch Auslesen des Abtast-Halteglieds 53 erhielt man das Signal 54, anhand dessen sich die Frequenzmodulation des Zwischenfrequenzsignals auswerten lässt.

**Patentansprüche**

1. Demodulator zur Demodulation von hochfrequenten Signalen, und insbesondere von Mobilfunksignalen, mit

    - einem Mischer (4), der das hochfrequente Signal in einen Zwischenfrequenzbereich heruntermischt, wobei der Mischer (4) ein Inphasesignal (7) sowie ein Quadratursignal (8) erzeugt,
    - einer Signalwandlereinheit (13, 32, 40), welche das Inphasesignal (7) sowie das Quadratursignal (8) in ein Ausgabesignal (14, 33, 41) von erhöhter Trägerfrequenz umsetzt, wobei die Signalwandlereinheit das Vorzeichen des Ausgabesignals in Abhängigkeit von dem Produkt der Vorzeichen des Inphase- und des Quadratursignals variiert, sowie
    - Mitteln (15, 17 ; 22, 24, 26 ; 34, 36, 38 ; 45, 47 ; 49, 51, 53) zur Bestimmung der Periodendauer oder der Frequenz des durch die Signalwandlereinheit erzeugten Ausgabesignals (14, 33, 41).

2. Demodulator nach Anspruch 1,
   **dadurch gekennzeichnet, dass**

    - der Demodulator dem Mischer (4) nachgeschaltete Kanalfilter (9, 10) für das Inphasesignal (7) und das Quadratursignal (8) umfasst, welche Frequenzen außerhalb des Zwischenfrequenzbereichs zumindest zum Teil unterdrücken.

3. Demodulator nach Anspruch 2,
   **dadurch gekennzeichnet, dass**

    - es sich bei den Kanalfiltern (9, 10) um Bandpässe, und insbesondere um komplexe Bandpässe handelt.

4. Demodulator nach einem der vorhergehenden Ansprüche,
   **dadurch gekennzeichnet, dass**

- die Signalwandlereinheit Mittel zur XOR-Verknüpfung (13, 32) des Inphasesignals (11) und des Quadratursignals (12) umfasst.

5. Demodulator nach Anspruch 4,
**dadurch gekennzeichnet, dass**

- das Inphasesignal (11) und das Quadratursignal (12) als analoge Signale ausgeführt sind, und dass die Mittel zur XOR-Verknüpfung (13) des Inphase- und des Quadratursignals in Analogtechnik ausgeführt sind.

6. Demodulator nach Anspruch 4,
**dadurch gekennzeichnet, dass**

- die Signalwandlereinheit Mittel zur Limitierung und Pegelanpassung (28, 29) des Inphasesignals (11) und des Quadratursignals (12) umfasst, und dass die Mittel zur XOR-Verknüpfung (32) des Inphase- und des Quadratursignals in digitaler Technik ausgeführt sind und die limitierten, pegelangepassten Signale (30, 31) verknüpfen.

7. Demodulator nach einem der Ansprüche 1 bis 3,
**dadurch gekennzeichnet, dass**

- die Signalwandlereinheit eine Multiplikatorstufe (40) zur Multiplikation des Inphasesignals (11) und des Quadratursignals (12) umfasst, wobei das Inphasesignal (11) und das Quadratursignal (12) als analoge Signale ausgeführt sind.

8. Demodulator nach einem der vorhergehenden Ansprüche,
**dadurch gekennzeichnet, dass**

- die Mittel zur Bestimmung der Periodendauer oder der Frequenz Flankendetektoren (22, 34, 49) zur Detektion der Signalflanken des Ausgabesignals der Signalwandlereinheit aufweisen.

9. Demodulator nach Anspruch 8,
**dadurch gekennzeichnet, dass**

- die Mittel zur Bestimmung der Periodendauer oder der Frequenz sowohl Flankendetektoren zur Detektion der ansteigenden Signalflanken als auch Flankendetektoren zur Detektion der abfallenden Signalflanken umfassen.

10. Demodulator nach einem der vorhergehenden Ansprüche,
**dadurch gekennzeichnet, dass**

- die Mittel zur Bestimmung der Periodendauer oder der Frequenz mindestens einen Zähldiskriminator (24, 36, 51) zur Erfassung der Zeitintervalle zwischen aufeinanderfolgenden ansteigenden oder abfallenden Signalflanken aufweisen.

11. Demodulator nach Anspruch 10,
**dadurch gekennzeichnet, dass**

- der mindestens eine Zähldiskriminator (24, 36, 51) einen Zähler umfasst, dessen Zählerstand durch einen Zähltakt hochgezählt wird, wobei der Zähler mit jedem Impuls des Flankendetektors (22, 34, 49) ausgelesen und rückgesetzt wird.

12. Demodulator nach einem der Ansprüche 1 bis 9,
**dadurch gekennzeichnet, dass**

- die Mittel zur Bestimmung der Periodendauer oder der Frequenz mindestens einen Integrator (15, 45) aufweisen, welcher das durch die Signalwandlereinheit erzeugte Ausgabesignal aufintegriert.

13. Demodulator nach einem der vorhergehenden Ansprüche,
**dadurch gekennzeichnet, dass**

- die Mittel zur Bestimmung der Periodendauer oder der Frequenz mindestens ein 1/x-Glied umfassen, mit dem die erfassten Periodendauern in zur Frequenz proportionale Werte umwandelbar sind.

14. Funkstation, welche einen Demodulator nach einem der Ansprüche 1 bis 13 aufweist.

15. Funkstation nach Anspruch 14,
**dadurch gekennzeichnet, dass**
die Funkstation für die Datenübertragung gemäß einem der Standards DECT oder Bluetooth ausgelegt ist.

16. Verfahren zur Demodulation von hochfrequenten Signalen, insbesondere von Mobilfunksignalen, **gekennzeichnet durch** folgende Schritte:

a) Heruntermischen des hochfrequenten Signals in einen Zwischenfrequenzbereich und Erzeugen eines Inphasesignals (7) sowie eines Quadratursignals (8);
b) Umwandeln des Inphasesignals (7) und des Quadratursignals (8) in ein Ausgabesignal (14, 33, 41) von erhöhter Trägerfrequenz, dessen Vorzeichen in Abhängigkeit von dem Produkt der Vorzeichen des Inphase- und des Quadratursignals variiert wird;

c) Bestimmen der Periodendauer oder der Frequenz, des Ausgabesignals (14, 33, 41).

17. Verfahren nach Anspruch 16,
**dadurch gekennzeichnet, dass**

- das Inphasesignal (11) und das Quadratursignal (12) mittels einer XOR-Verknüpfung (13, 32) in das Ausgabesignal (14, 33) umgewandelt werden.

18. Verfahren nach Anspruch 16,
**dadurch gekennzeichnet, dass**

- das Ausgabesignal (41) durch Multiplikation (40) des Inphasesignals (11) mit dem Quadratursignal (12) erhalten wird.

19. Verfahren nach einem der Ansprüche 16 bis 18,
**dadurch gekennzeichnet, dass**

- zur Bestimmung der Periodendauer oder der Frequenz des Ausgabesignals (14, 33, 41) die Signalflanken des Ausgabesignals erfasst werden.

20. Verfahren nach Anspruch 19,
**dadurch gekennzeichnet, dass**

- zur Bestimmung der Periodendauer oder der Frequenz des Ausgabesignals die Zeitintervalle zwischen aufeinanderfolgenden ansteigenden oder abfallenden Signalflanken erfasst werden.

21. Verfahren nach einem der Ansprüche 16 bis 19,
**dadurch gekennzeichnet, dass**

- zur Bestimmung der Periodendauer oder der Frequenz des Ausgabesignals eine Integration (15, 45) des Ausgabesignals (14, 41) vorgenommen wird.

22. Verfahren nach einem der Ansprüche 16 bis 21,
**dadurch gekennzeichnet, dass**

- die erfassten Periodendauern mittels eines 1/x-Glieds in zur Frequenz proportionale Werte umgewandelt werden.

**Claims**

1. Demodulator for demodulating radiofrequency signals, and in particular mobile radio signals, having

- a mixer (4), which downconverts the radiofrequency signal into an intermediate frequency range, the mixer (4) generating an in-phase signal (7) and also a quadrature signal (8),

- a signal converter unit (13, 32, 40), which converts the in-phase signal (7) and also the quadrature signal (8) into an output signal (14, 33, 41) of increased carrier frequency, the signal converter unit varying the sign of the output signal in a manner dependent on the product of the signs of the in-phase signal and of the quadrature signal, and also

- means (15, 17; 22, 24, 26; 34, 36, 38; 45, 47; 49, 51, 53) for determining the period duration or the frequency of the output signal (14, 33, 41) generated by the signal converter unit.

2. Demodulator according to Claim 1,
**characterized in that**

- the demodulator comprises channel filters (9, 10) for the in-phase signal (7) and the quadrature signal (8), which are connected downstream of the mixer (4) and suppress, at least in part, frequencies outside the intermediate frequency range.

3. Demodulator according to Claim 2,
**characterized in that**

- the channel filters (9, 10) are bandpass filters, and in particular complex bandpass filters.

4. Demodulator according to one of the preceding claims,
**characterized in that**

- the signal converter unit comprises means for the XOR combination (13, 32) of the in-phase signal (11) and of the quadrature signal (12).

5. Demodulator according Claim 4,
**characterized in that**

- the in-phase signal (11) and the quadrature signal (12) are embodied as analogue signals, and **in that** the means for the XOR combination (13) of the in-phase signal and of the quadrature signal are embodied using analogue technology.

6. Demodulator according to Claim 4,
**characterized in that**

- the signal converter unit comprises means for the limiting and level matching (28, 29) of the in-phase signal (11) and of the quadrature signal (12) and **in that** the means for the XOR combination (32) of the in-phase signal and of the quadrature signal are embodied using digital technology and combine the limited, level-matched signals (30, 31).

7. Demodulator according to one of Claims 1 to 3, **characterized in that**

- the signal converter unit comprises a multiplier stage (40) for multiplying the in-phase signal (11) and the quadrature signal (12), the in-phase signal (11) and the quadrature signal (12) being embodied as analogue signals.

8. Demodulator according to one of the preceding claims, **characterized in that**

- the means for determining the period duration or the frequency have edge detectors (22, 34, 49) for detecting the signal edges of the output signal of the signal converter unit.

9. Demodulator according to Claim 8, **characterized in that**

- the means for determining the period duration or the frequency comprise both edge detectors for detecting the rising signal edges and edge detectors for detecting the falling signal edges.

10. Demodulator according to one of the preceding claims, **characterized in that**

- the means for determining the period duration or the frequency have at least one counting discriminator (24, 36, 51) for detecting the time intervals between successive rising or falling signal edges.

11. Demodulator according to Claim 10, **characterized in that**

- the at least one counting discriminator (24, 36, 51) comprises a counter whose counter reading is counted up by a counting clock, the counter being read and reset with each pulse of the edge detector (22, 34, 49).

12. Demodulator according to one of Claims 1 to 9, **characterized in that**

- the means for determining the period duration or the frequency have at least one integrator (15, 45), which integrates the output signal generated by the signal converter unit.

13. Demodulator according to one of the preceding claims, **characterized in that**

- the means for determining the period duration or the frequency comprise at least one 1/x element, with which the detected period durations can be converted into values proportional to the frequency.

14. Radio station, which has a demodulator according to one of Claims 1 to 13.

15. Radio station according to Claim 14, **characterized in that**
the radio station is designed for data transmission in accordance with one of the standards DECT or Bluetooth.

16. Method for demodulating radiofrequency signals, in particular mobile radio signals, **characterized by** the following steps:

a) downconversion of the radiofrequency signal into an intermediate frequency range and generation of an in-phase signal (7) and also of a quadrature signal (8);
b) conversion of the in-phase signal (7) and of the quadrature signal (8) into an output signal (14, 33, 41) of increased carrier frequency, the sign of which is varied in a manner dependent on the product of the signs of the in-phase signal and of the quadrature signal;
c) determination of the period duration or of the frequency of the output signal (14, 33, 41).

17. Method according to Claim 16, **characterized in that**

- the in-phase signal (11) and the quadrature signal (12) are converted into the output signal (14, 33) by means of an XOR combination (13, 32).

18. Method according to Claim 16, **characterized in that**

- the output signal (41) is obtained by multiplication (40) of the in-phase signal (11) by the quadrature signal (12).

19. Method according to one of Claims 16 to 18, **characterized in that**

- the signal edges of the output signal are detected in order to determine the period duration or the frequency of the output signal (14, 33, 41).

20. Method according to Claim 19, **characterized in that**

- the time intervals between successive rising or falling signal edges are detected in order to determine the period duration or the frequency of the output signal.

21. Method according to one of Claims 16 to 19, **characterized in that**

    - an integration (15, 45) of the output signal (14, 41) is performed in order to determine the period duration or the frequency of the output signal.

22. Method according to one of Claims 16 to 21, **characterized in that**

    - the detected period durations are converted into values proportional to the frequency by means of a 1/x element.


**Revendications**

1. Démodulateur pour démoduler des signaux haute fréquence, et en particulier des signaux de radiotéléphonie mobile, comportant

    - un mélangeur (4) qui abaisse par mélange le signal haute fréquence dans une gamme de fréquence intermédiaire, le mélangeur (4) produit alors un signal en phase (7) ainsi qu'un signal déphasé en quadrature (8),
    - une unité pour convertir les signaux (13, 32, 40) qui convertit le signal en phase (7) ainsi que le signal déphasé en quadrature (8) en un signal à la sortie (14, 33, 41) dont la fréquence porteuse est plus élevée, l'unité pour convertir les signaux fait alors varier le signe du signal à la sortie en fonction du produit des signes que présentent le signal en phase et le signal déphasé en quadrature et
    - des moyens (15, 17 ; 22, 24, 26 ; 34, 36, 38 ; 45, 47 ; 49, 51, 53) pour déterminer la durée de période ou la fréquence que présente le signal à la sortie (14, 33, 41) produit par l'unité pour convertir les signaux.

2. Démodulateur selon la revendication 1, **caractérisé en ce que**

    - le démodulateur comprend des filtres de canal (9, 10), situés en aval du mélangeur (4) et destinés au signal en phase (7) et au signal déphasé en quadrature (8), qui suppriment au moins en partie les fréquences en-dehors de la gamme de fréquence intermédiaire.

3. Démodulateur selon la revendication 2, **caractérisé en ce que**

    - les filtres de canal (9, 10) sont des filtres passe-bande, en particulier des filtres passe-bande complexes.

4. Démodulateur selon l'une des revendications précédentes, **caractérisé en ce que**

    - l'unité pour convertir les signaux comprend des moyens pour relier par ou exclusif (13, 32) le signal en phase (11) et le signal déphasé en quadrature (12).

5. Démodulateur selon la revendication 4, **caractérisé en ce que**

    - le signal en phase (11 ) et le signal déphasé en quadrature (12) prennent la forme de signaux analogiques et les moyens pour relier par ou exclusif (13) le signal en phase et le signal déphasé en quadrature sont réalisés selon la technique analogique.

6. Démodulateur selon la revendication 4, **caractérisé en ce que**

    - l'unité pour convertir les signaux comprend des moyens pour limiter et pour ajuster en niveau (28, 29) le signal en phase (11) et le signal déphasé en quadrature (12) et les moyens pour relier par ou exclusif (32) le signal en phase et le signal déphasé en quadrature sont réalisés selon la technique numérique et relient les signaux (30, 31) limités et ajustés en niveau.

7. Démodulateur selon l'une des revendications 1 à 3, **caractérisé en ce que**

    - l'unité pour convertir les signaux comprend un étage de multiplication (40) pour multiplier le signal en phase (11) et le signal déphasé en quadrature (12), le signal en phase (11) et le signal déphasé en quadrature (12) prenant la forme de signaux analogiques.

8. Démodulateur selon l'une des revendications précédentes, **caractérisé en ce que**

    - les moyens pour déterminer la durée de période ou la fréquence présentent des détecteurs de front (22, 34, 49) pour détecter les fronts de signal dans le signal à la sortie sur l'unité pour convertir les signaux.

9. Démodulateur selon la revendication 8, **caractérisé en ce que**

    - les moyens pour déterminer la durée de période ou la fréquence comprennent aussi bien des détecteurs de front pour détecter les fronts croissants des signaux que des détecteurs de front pour détecter les fronts décroissants des signaux.

10. Démodulateur selon l'une des revendications précédentes, **caractérisé en ce que**

   - les moyens pour déterminer la durée de période ou la fréquence présentent au moins un discriminateur de nombre (24, 36, 51) pour enregistrer les intervalles de temps entre des fronts successifs croissants ou décroissants des signaux.

11. Démodulateur selon la revendication 10, **caractérisé en ce que**

   - le discriminateur de nombre (24, 36, 51), au moins au nombre d'un, comprend un compteur dont l'état est incrémenté par une impulsion de comptage, le compteur étant lu et réinitialisé à chaque impulsion du détecteur de front (22, 34, 49).

12. Démodulateur selon l'une des revendications 1 à 9, **caractérisé en ce que**

   - les moyens pour déterminer la durée de période ou la fréquence présentent au moins un intégrateur (15, 45) qui intègre le signal à la sortie produit par l'unité pour convertir les signaux.

13. Démodulateur selon l'une des revendications précédentes, **caractérisé en ce que**

   - les moyens pour déterminer la durée de période ou la fréquence comprennent au moins un organe 1/x grâce auquel les durées de période enregistrées peuvent être converties en valeurs proportionnelles à la fréquence.

14. Poste radio qui comporte un démodulateur selon l'une des revendications 1 à 13.

15. Poste radio selon la revendication 14, **caractérisé en ce que** le poste radio pour transmettre des données est conçu d'après l'une des normes DECT ou Bluetooth.

16. Procédé pour démoduler des signaux haute fréquence, en particulier des signaux de radiotéléphonie mobile, **caractérisé par** les étapes suivantes:

   a) on abaisse par mélange le signal haute fréquence dans une gamme de fréquence intermédiaire et on produit un signal en phase (7) ainsi qu'un signal déphasé en quadrature (8) ;

   b) on convertit le signal en phase (7) et le signal déphasé en quadrature (8) en un signal à la sortie (14, 33, 41) dont la fréquence porteuse est plus élevée et dont le signe est modifié en fonction du produit des signes que présentent le signal en phase et le signal déphasé en quadrature ;

   c) on détermine la durée de période ou la fréquence du signal à la sortie (14, 33, 41).

17. Procédé selon la revendication 16, **caractérisé en ce que**

   - le signal en phase (11) et le signal déphasé en quadrature (12) sont convertis en signal à la sortie (14, 33) à l'aide d'une liaison par ou exclusif (13, 32).

18. Procédé selon la revendication 16, **caractérisé en ce que**

   - le signal à la sortie (41) est obtenu en multipliant (40) le signal en phase (11) par le signal déphasé en quadrature (12).

19. Procédé selon l'une des revendications 16 à 18, **caractérisé en ce que**

   - on enregistre les fronts de signal du signal à la sortie afin de déterminer la durée de période ou la fréquence du signal à la sortie (14, 33, 41).

20. Procédé selon la revendication 19, **caractérisé en ce que**

   - on enregistre les intervalles de temps entre des fronts successifs croissants ou décroissants des signaux afin de déterminer la durée de période ou la fréquence du signal à la sortie.

21. Procédé selon l'une des revendications 16 à 19, **caractérisé en ce que**

   - on effectue une intégration (15, 45) du signal à la sortie (14,41) afin de déterminer la durée de période ou la fréquence du signal à la sortie.

22. Procédé selon l'une des revendications 16 à 21, **caractérisé en ce que**

   - les durées de période enregistrées sont converties. en valeurs proportionnelles à la fréquence à l'aide d'un organe 1/x.

Fig. 1

Fig. 2A

Fig. 2B

EP 1 417 749 B1

Fig. 3A

Fig. 3B